## Europäisches Patentamt

(19) **European Patent Office**

**Office européen des brevets**

(11) Veröffentlichungsnummer: **0 073 929**
**B1**

(12) **EUROPÄISCHE PATENTSCHRIFT**

(45) Veröffentlichungstag der Patentschrift:
20.07.88

(21) Anmeldenummer: **82107010.9**

(22) Anmeldetag: **03.08.82**

(51) Int. Cl.⁴: **H 03 C 1/54,** H 03 D 7/14,
H 03 D 3/22, H 03 G 1/00

(54) Integrierbare signalverarbeitende Halbleiterschaltung.

(30) Priorität: 03.09.81 DE 3134936

(43) Veröffentlichungstag der Anmeldung:
16.03.83 Patentblatt 83/11

(45) Bekanntmachung des Hinweises auf die Patenterteilung:
20.07.88 Patentblatt 88/29

(84) Benannte Vertragsstaaten:
DE FR GB IT

(56) Entgegenhaltungen:
DE-A-2 910 245
DE-B-2 853 024
FR-A-2 082 468
US-A-4 065 725
US-A-4 227 256
US-A-4 262 261

UNION DES ASSOCIATIONS TECHNIQUES
INTERNATIONALES ET LA SOCIETE FRANCAISE
DES ELECTRONICIENS ET DES
RADIOELECTRICIENS. COLLOQUE
INTERNATIONAL SUR LA MICROELECTRONIQUE
AVANCEE, Paris 6.-10. April 1970, Seiten 911-921,
Chiron, Paris, FR; B. MURARI u.a.: "Integrated
balanced modulator II 103"

(73) Patentinhaber: **Siemens Aktiengesellschaft Berlin
und München, Wittelsbacherplatz 2, D-8000
München 2 (DE)**

(72) Erfinder: **Kriedt, Hans, Ing. grad., Triester Strasse
33, D-8000 München 80 (DE)**
Erfinder: **Dietze, Andreas, Dipl.- Ing.,
Teufelsgrabenweg 4, D-8155 Valley/Grub (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine integrierbare signalverarbeitende Halbleiterschaltung, nach dem Oberbegriff des Patentanspruchs 1.

Eine derartige Schaltung, bei der die Stromeingangselektroden der Transistoren des ersten Differenzverstärkers über die stromführende Strecke eines fünften Transistors sowie die Stromeingangselektroden der Transistoren des zweiten Differenzverstärkers über die stromführende Strecke eines sechsten Transistors an das Bezugspotential der Schaltung und die Stromausgangselektroden der an den beiden Ausgangsklemmen liegenden Transistoren der beiden Differenzverstärker an das andere Versorgungspotential gelegt, die beiden Ausgangsklemmen auf das Bezugspotential der Schaltung bezogen und die Steuerelektroden des fünften und sechsten Transistors mit einem zweiten Differenzsignal beaufschlagt sind, ist in "Siemens Integrierte Schaltungen für die Unterhaltungselektronik, Datenbuch 1980/81, S. 294 und 295" dargestellt. Diese Schaltung ist auch aus der DE-B-2 853 024 bekannt, wobie die Emitteranschlüsse des besagten fünften und sechsten Transistors an je einen Stromausgang eines Stromspiegelverstärkers, der einen Steuereingang und zwei Stromausgänge aufweist, angeschlossen ist.

Die bekannte Schaltung kann u. a. als Mischstufe, als Koinzidenzdemodulator, als AM-Modulator und -Demodulator sowie als Lautstärketeiler verwendet werden. Sie verlangt jedoch höhere Versorgungsspannungen. Demgegenüber ist gemäß der Erfindung eine für diese und auch weitere Funktionen geeignete Schaltung zu realisieren, welche mit niedrigen, d. h. bei etwa 1 Volt liegenden Versorgungsspannungen betrieben werden kann und dennoch eine gute Stabilität sowie ein gutes ((S + N)/N)-Verhältnis (S = Signalamplitude und N = Amplitude des Rauschens) auch bei einem Einsatz von Signalen unterhalb des Begrenzungseinsatzes aufweist. Zusätzlich soll die erfindungsgemäße Schaltung den Vorteil einer gleichen Laufzeit in beiden Signalwegen zum Mischer bieten, was beim Mischen zweier korrelierter Signale, z. B. für AM- und FM Demodulation, wichtig ist.

Um das Verlangte zu erreichen, wird gemäß der Erfindung eine der eingangs gegebenen Definition entsprechende Halbleiterschaltung derart ausgestaltet, daß die beiden außerhalb des ersten und des zweiten Differenzverstärkers liegenden Transistoren durch den Ausgangstransistor je eines Stromspiegelverstärkers gegeben und außerdem noch zwei weitere Stromspiegel und bei weiteren Differenzverstärker vorgesehen sind, daß dabei je einer der beiden Ausgänge des dritten Differenzverstärkers zur Steuerung je eines der beiden mit den Stromeingangselektroden der Transistoren des ersten und des zweiten

Differenzverstärkers verbundenen Stromspiegelverstärkers dient, während die restlichen beiden Stromspiegelverstärker durch je einen der beiden Ausgänge des vierten Differenzverstärkers gesteuert sind und ihrerseits mit ihrem Ausgang an die Steuerelektrode je eines der beiden Transistoren des ersten Differenzverstärkers gelegt und die Steuerelektroden der beiden Transistoren des ersten Differenzverstärkers über je ein Lastelement an das - nicht als Bezugspotential verwendete - andere Versorgungspotential der Schaltung gelegt sind.

Die Erfindung wird nun anhand der Zeichnungen näher beschrieben. Dabei ist in Figur 1 der Stand der Technik und in Figur 2 ein der Erfindung entsprechendes Blockschaltbild und in Figur 3 eine auf dieses Blockschaltbild bezogene weitere Ausgestaltung am Beispiel eines FM-Demodulators dargestellt. In den Figuren 4 bis 6 sind detaillierte, bevorzugte Ausgestaltungen der erfindungsgemäßen Schaltung gebracht.

Zu bemerken ist dabei, daß bei den in den Figuren gebrachten Ausführungsbeispielen ausschließlich bipolare Transistoren verwendet sind, bei denen somit die Steuerelektrode durch den Basisanschluß, die Stromeingangselektrode durch den Emitteranschluß und die Stromausgangselektrode durch den Kollektoranschluß gegeben ist. Es können aber auch noch andere Transistortypen, z. B. selbstsperrenden MOS-Feldeffekttransistoren, verwendet werden. Die Stromeingangselektrode ist dann mit dem Sourceanschluß, die Stromausgangselektrode mit dem Drainanschluß und die Steuerelektrode mit dem Gate des Feldeffekttransistors zu identifizieren.

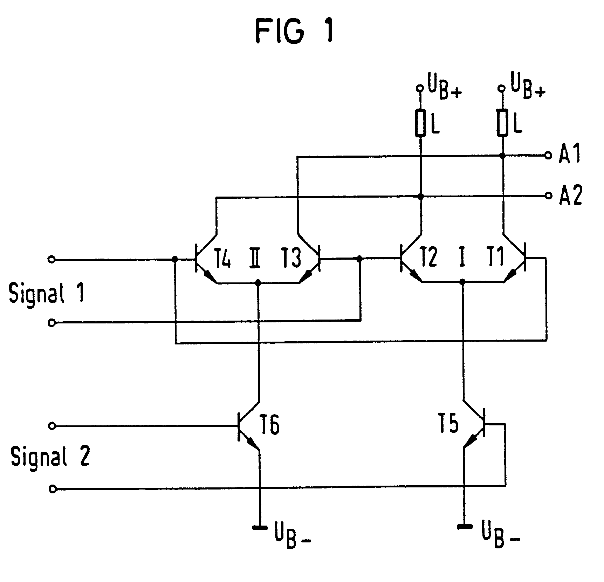

Bei dem in Figur 1 dargestellten und den Ausgangspunkt der Erfindung bildenden Schaltbild hat man zwei emittergekoppelte Differenzverstärker I und II, die unter Verwendung von vier npn-Transistoren T1 bis T4 aufgebaut sind. Die Basisanschlüsse des Transistors T1 des ersten Differenzverstärkers 1 und die Basis des Transistors T4 des zweiten Differenzverstärkers II sind gemeinsam an einer ersten Signaleingangsklemme und die Basisanschlüsse des Transistors T2 des ersten und des Transistors T3 des zweiten Differenzverstärkers gemeinsam an einer zweiten Signaleingangsklemme angeschlossen. Die beiden Signaleingangsklemmen sind gemeinsam durch ein erstes Signal beaufschlagt. Ferner liegt der Kollektor des Transistors T1 und der Kollektor des Transistors T3 einerseits an einer gemeinsamen Klemme A2 für das Ausgangssignal und über ein z. B. durch einen Widerstand gegebenes gemeinsames Lastelement L an dem Betriebspotential $U_{B+}$, das nicht als das Bezugspotential der Schaltung verwendet ist. Ebenso sind die Kollektoren der beiden anderen Transistoren T2 und T4 gemeinsam an eine zweite Klemme A1 für das Ausgangssignal gelegt und außerdem über ein gemeinsames Lastelement L mit dem soeben genannten Betriebspotential $U_{B+}$ verbunden. Zwei weitere npn-Transistoren T5 und T6 liegen mit ihren Emittern (ggf. unter Verwendung je eines Widerstandes) an dem Anschluß für das als Bezugspotential verwendete Betriebspotential $U_{B-}$ und bilden mit ihren Basiselektroden je eine Anschlußklemme für ein zweites Eingangssignal. Schließlich liegt der Kollektor des npn-Transistors T5 an den Emittern der beiden Transistoren T1 und T2 des ersten Differenzverstärkers I und der Kollektor des npn-Transistors T6 an den Emittern der Transistoren T3 und T4 des zweiten Differenzverstärkers II.

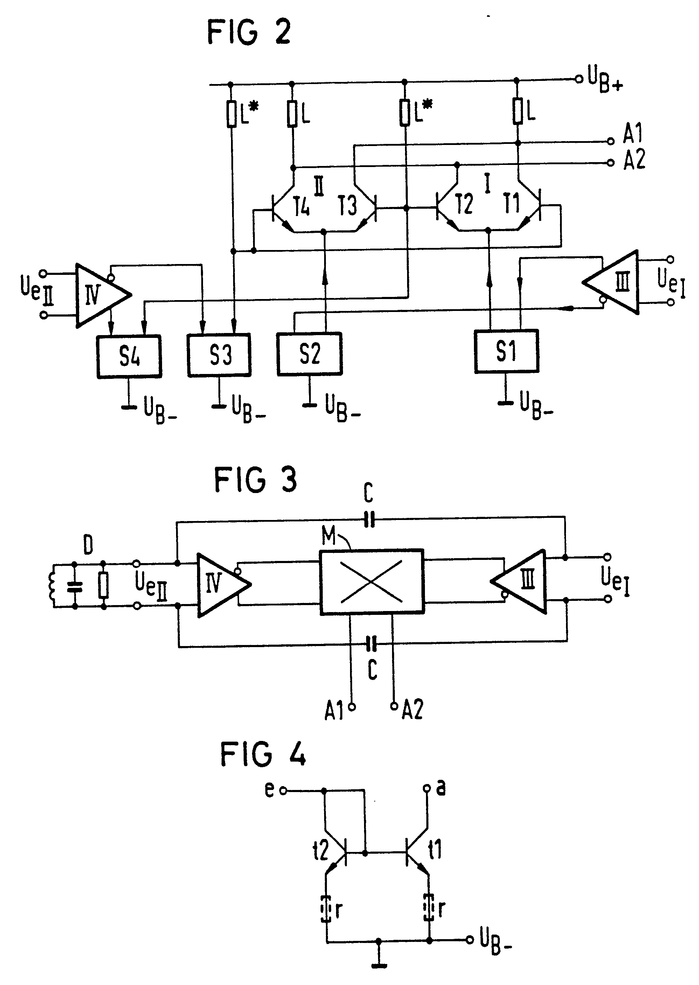

Die soeben beschriebene und in Figur 1 dargestellte Schaltung gehört zum Stande der Technik. Sie bildet auch einen Bestandteil der in Figur 2 im Blockschaltbild dargestellten erfindungsgemäßen Halbleiterschaltung. Wie aus Fig. 2 ersichtlich besteht der erste Differenzverstärker 1 aus den beiden npn-Transistoren T1 und T2 und der zweite Differenzverstärker II aus den beiden npn-Transistoren T3 und T4, wie im Falle der Fig. 1. Die beiden Transistoren des ersten Differenzverstärkers I sind mit ihren Emittern - eventuell über Widerstände - miteinander verbunden, wobei der Verbindungsmittelpunkt außerdem am Ausgang eines ersten Stromspiegelverstärkers S1 liegt. Die beiden Transistoren T3, T4 des zweiten Differenzverstärkers II sind über ihre Emitter (eventuell auch über Widerstände) ebenfalls miteinander verbunden und liegen außerdem ebenfalls am Ausgang eines zweiten Stromspiegelverstärkers S2. Beide Stromspiegelverstärker S1 und S2 sowie die noch vorzustellenden Stromspiegelverstärker S3 und S4 liegen an der das Bezugspotential $U_{B-}$ liefernden Versorgungsklemme.

Die Basisanschlüsse des Transistors T1 des ersten Differenzverstärkers I und des Transistors T4 des zweiten Differenzverstärkers II sind miteinander verbunden und liegen über ein gemeinsames Lastglied L* (z. B. einem Widerstand) an der das andere Versorgungspotential $U_{B+}$ liefernden Versorgungsklemme sowie am Ausgang eines dritte Stromspiegelverstärkers S3. Die Basisanschlüsse der beiden anderen Transistoren T2 und T3 der beiden Differenzverstärker I und II sind ebenfalls miteinander verbunden und liegen über ein weiteres Lastglied L* an dem anderen Versorgungspotential $U_{B+}$ sowie am Ausgang eines vierten Stromspiegelverstärkers S4. Die vier Stromspiegelverstärker S1 bis S4 bestehen in bekannter Weise aus Transistoren vom Typ der Transistoren der beiden Differenzverstärker I und II, d. h. also im Beispielsfalle aus npn-Transistoren vom Bipolartyp. Gewöhnlich wird eine Schaltung angewendet, wie sie in Figur 4 dargestellt ist.

Der Kollektor des Transistors T2 des ersten Differenzverstärkers I (der seinerseits über seine Basis mit dem Transistor T3 des zweiten Differenzverstärkers II verbunden ist) und der Kollektor des Transistors T4 des zweiten Differenzverstärkers II (der seinerseits über seine Basis mit dem Transistor T1 des ersten Differenzverstärkers verbunden ist) sind miteinander verbunden und liegen über ein Lastelement L an der das andere Versorgungspotential $U_{B+}$ liegenden Versorgungsklemme. Die Kollektoren der beiden übrigen Transistoren T1 und T3 sind ebenfalls miteinander verbunden und liegen über ein weiteres Lastelement ebenfalls an der soeben genannten Versorgungsklemme $U_{B+}$. Die Verbindungspunkte zwischen den Kollektorenpaaren und den Lastelementen bilden, ebenso wie bei der Schaltung gemäß Figur 1, auch hier die beiden Ausgangsklemmen A1 und A2. Bevorzugt erscheint das auszuwertende Ausgangssignal zwischen den beiden Klemmen A1 und A2. Es kann aber auch von Bedeutung sein, das zwischen der Klemme A1 bzw. der Klemme A2 einerseits und der das Bezugspotential liefernden Klemme $U_{B-}$ jeweils auftretende Signal als je ein Ausgangssignal der Schaltung zu verwenden.

Ein in üblicher Weise aus zwei (evtl. über Emitterwiderstände) emittergekoppelten Transistoren aufgebauter dritter Differenzverstärker III erhält an seinem durch die Basisanschlüsse seiner beiden Transistoren gebildeten Signaleingang ein Steuersignal $U_{el}$. Die Kollektoren der beiden Transistoren des dritten Differenzverstärkers III bilden je einen Ausgang, wobei der eine zur Steuerung des ersten Stromspiegelverstärkers S1 und der andere zur Steuerung des zweiten Stromspiegelverstärkers S2 vorgesehen ist.

Ein dem dritten Differenzverstärker III im Aufbau entsprechender vierter Differenzverstärker IV dient mit seinem einen Ausgang zur Steuerung des dritten Stromspiegelverstärkers S3 und mit seinem anderen Ausgang zur Steuerung des vierten Stromspiegelverstärkers S4. Er wird durch ein Eingangsignal $U_{ell}$ beaufschlagt.

Bei einer Forderung nach gleicher Laufzeit in den beiden Signalzweigen, wie sie z B. bei einem FM-Demodulator erwünscht ist, müssen einerseits die beiden Differenzverstärker III und IV und andererseits die vorgesehenen Stromspiegelverstärker S1 bis S4 einander gleich sein.

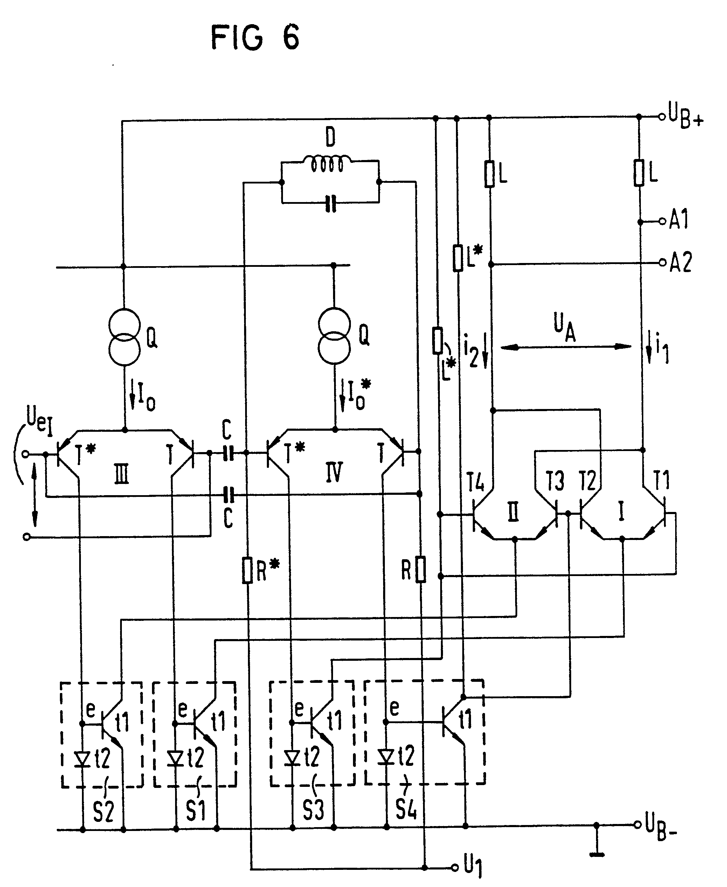

Aus Figur 3 ist das Blockschaltbild der erfindungsgemäßen Schaltung zu ersehen, wenn diese als FM-Koinzidenzdemodulator verwendet werden soll. Sie entspricht dem detaillierten Schaltbild gemäß Figur 6. Der durch das Signal $U_{el}$ gesteuerte Signaleingang des dritten Differenzverstärkers III erhält sein Signal unmittelbar, während zur Steuerung des vierten Differenzverstärkers IV dasselbe Signal unter Vermittlung je eines Koppelkondensators C an die beiden Eingangsanschlüsse dieses Differenzverstärkers IV gelegt ist. Dabei bildet sich bei Sollabstimmung an dem zwischen den Eingangsklemmen des vierten Differenzverstärkers IV geschalteten Diskriminatorkreis D ein um 90° phasenverschobenes Signal $U_{ell}$. Der mit M bezeichnete Schaltungsteil entspricht der Kombination der vier Stromspiegelverstärker S1 - S4 mit den beiden ersten Differenzverstärkern I und II.

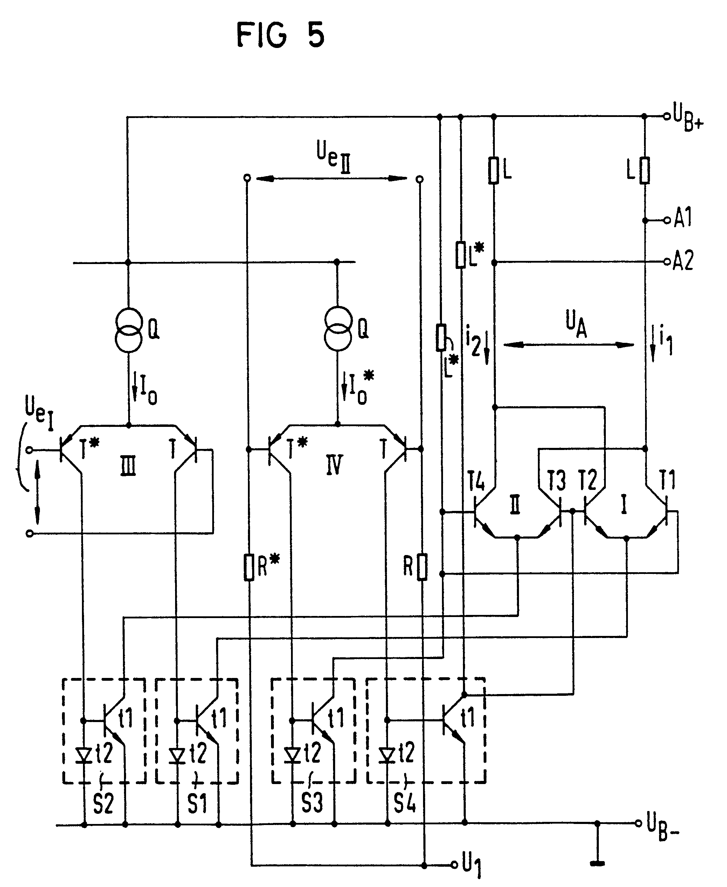

Im Falle der aus den Figuren 5 und 6 ersichtlichen Ausgestaltung der erfindungsgemäßen Anlage dient die in Flußrichtung gepolte Vergleichsdiode t2 der vier Stromspiegelverstärker S1 bis S4 jeweils als Lastelement für je einen Zweig der beiden aus je zwei pnp-Transistoren gleicher Eigenschaften aufgebauten Differenzverstärker III und IV, das die Verbindung zum Bezugspotential $U_{B-}$ bildet. Die Verbindung zum anderen Versorgungspotential $U_{B+}$ geschieht über je eine Stromquelle, die in die Differenzverstärker III und IV den Strom $I_o$ bzw. den Strom $I_o^*$ einprägt.

Die Realisierung der vier Stromspiegelverstärker S1 bis S4 geschieht am zweckmäßigsten in der aus Figur 4 ersichtlichen Weise, indem in üblicher Weise die Diode t2 durch einen Transistor vom Typ des Ausgangstransistors t1 des Stromspiegels (hier vom npn-Typ) realisiert wird. Durch kurz schließen der Kollektor-Basisstrecke kommt bei dem Transistor t2 nur die Emitter-Basis-Diode zur Geltung. In gleicher Weise kann bei Verwendung eines Stromspiegels für aus den Figuren 5 und 6 ersichtlichen Stromquellen Q schaltungsmäßig vorgegangen werden, mit dem einzigen Unterschied, daß dann die beiden Transistoren pnp-Transistoren sind, deren Emitter mit der das andere Versorgungspotential $U_{B+}$ liefernden Versorgungsklemme verbunden sind. Wie aus Figur 4 ersichtlich, können die Emitter der Stromspiegeltransistoren t1 und t2 über Widerstände r an das zugeordnete Versorgungspotential angeschlossen sein.

Die Signaleingänge für $U_{el}$ und $U_{ell}$ des dritten und des vierten Differenzverstärkers III und IV können (wie beim Differenzverstärker IV in Figur 5 und 6 ersichtlich) durch Widerstände R bzw. R* an einem z. B. mittels eines Spannungsteilers aus der Versorgungsspannung abgeleiteten Hilfspotential $U_1$ liegen. An sich wäre auch eine ausschließliche Beaufschlagung der Signaleingänge durch eine Signalquelle mit einem Gleichspannungs- und einem Wechselspannungsteil möglich.

Die in Figur 6 dargestellte Schaltung gemäß der Erfindung unterscheidet sich von einer Schaltung gemäß Figur 5 lediglich dadurch, daß die Eingangsklemmen des dritten, d. h. des zur Steuerung der am ersten und am zweiten Differenzverstärker I und II liegenden Stromspiegeln dienenden Differenzverstärkers III (d. h. also die Basisanschlüsse seiner beiden Transistoren T und T*) mit den entsprechenden Anschlüssen des vierten Differenzverstärkers IV über einen Phasenschieber verbunden sind. Dies geschieht durch Zusammenschalten der Basisanschlüsse der Transistoren T und T* des dritten Differenzverstärkers mit den entsprechenden Basisanschlüssen im vierten Differenzverstärker über je einen Kondensator C und das Anschalten eines in der Ersatzschaltung verlustbehafteten Parallelschwingkreises zwischen die Basisanschlüsse eines Differenzverstärkers (hier des Differenzverstärkers IV).

Die in Figur 5 dargestellte Schaltung gemäß der Erfindung stellt ersichtlich einen multiplikativen Mischer dar. Liegt zwischen den beiden Eingangsklemmen des dritten Differenzverstärkers III ein Signal
$$U_{el} \sim \sin \omega_1 t$$
und an den beiden Eingangsklemmen des vierten Differenzverstärkers IV ein Signal
$$U_{ell} \sim \sin \omega_2 t,$$
so erscheint zwischen den beiden Ausgangsklemmen A1 und A2 ein Signal
$$U_A \sim |n\omega_1 \pm m\omega_2|$$
mit n = 1 (2)∞ und m = 1 (2)∞.
Das zwischen der Ausgangsklemme A2 und der Bezugspotentialklemme $U_{B-}$ liegende Ausgangssignal ist dann durch die gleiche Proportionalität wie $U_A$ gegeben, während das Signal zwischen der Ausgangsklemme A1 und der Bezugspotentialklemme $U_{B-}$ um 180° phasenverschoben ist.

Ändert man die in Figur 5 dargestellte Schaltung in der aus Figur 2 bzw. Figur 6 ersichtlichen Weise ab, so bildet die dann erhaltene Schaltung einen Demodulator für winkelmodulierte Signale. Dazu gelangt das direkte Signal am Eingang $U_{el}$ des Differenzverstärkers III, das durch den Ausdruck
$$u_e = f((\varphi_m \pm \Delta\varphi) \cdot t)$$
gegeben ist, über den Differenzverstärker III auf die Stromspiegel S1 und S2 und steht als signalführender Strom für die Transistoren T1 bis T4 der beiden ersten Differenzverstärker I und II zur Verfügung. Das dank der Anwesenheit des Diskriminators (bestehend aus C und D) um 90° phasenverschobene Signal
$$u_p = f(\varphi_m \pm \Delta\varphi) \cdot t + \tfrac{\pi}{2} + \varphi$$
wird über den vierten Differenzverstärker IV und den beiden Stromspiegelverstärkern S3 und S4 in derselben Weise aufbereitet und steht dann als Differenzspannung an den Lastwiderständen L* als zweite Steuergröße für die Mischstufe (bestehend aus den Differenzverstärkern I und II) zur Verfügung. Die Ströme in den Kollektoren der Transistoren T1 und T4 des ersten und des zweiten Differenzverstärkers I bzw. II liefern das an den Ausgangsklemmen A1 und A2 erscheinende Signal $f(u_e, u_p)$.

Die in Figur 6 dargestellte Schaltung ist besonders vorteilhaft, weil es sich gezeigt hat, daß noch bei sehr kleinen Versorgungsspannungen $U_B$ z. B. von 1 Volt, noch eine einwandfreie Funktion der Schaltung gegeben ist. Ein weiterer Vorteil liegt darin, daß - bedingt durch gleiche Laufzeit in den beiden Signalzweigen - der Offset der Diskriminatorkurve klein gehalten werden kann.

Wesentlich ist u.a. auch die aus den Figuren 4 bis 6 ersichtliche Ausgestaltung der Stromspiegel S1, S2, S3 und S4, die an sich üblich ist. Zu bemerken ist noch, daß in Figur 5 und 6 der Eingangstransistor t2 der Stromspiegel S1 bis S4 der einfachheit halber als Diode gezeichnet ist und ggf. auch durch eine solche ersetzt werden kann.

## Patentansprüche

1. Integrierbare signalverarbeitende Halbleiterschaltung, bei der vier einander gleiche Transistoren (T1, T2, T3, T4) paarweise über ihre Stromeingangselektroden (z. B. Emitterelektroden) unter Entstehung eines ersten und eines zweiten Differenzverstärkers (I, II) zusammengefaßt sind, bei der dabei vom ersten Differenzverstärker (I) und vom zweiten Differenzverstärker (II) je ein Transistor (T2, T3) über die Steuerelektrode (z. B. Basis) miteinander verbunden und durch ein erstes Signal beaufschlagt sind, während die ebenfalls miteinander verbundenen Steuerelektroden der beiden anderen Transistoren (T1, T4) ihrerseits durch ein z. B. zum ersten Signal gegenphasiges Signal gesteuert sind, bei der außerdem die vier Transistoren (T1, T2, T3, T4) der beiden Differenzverstärker (I, II) über ihre Stromausgangselektroden (z. B. Kollektoren) derart zusammengefaßt und an je eine der beiden Signalausgangsklemmen (A1, A2) gelegt sind, daß die zwei jeweils an der gleichen Ausgangsklemme liegenden Transistoren lediglich über ihre Stromausgangselektroden in unmittelbarer Verbindung miteinander stehen und die Stromausgangselektroden der an den beiden Ausgangsklemmen liegenden Transistoren der beiden Differenzverstärker (I, II) an das Versorgungspotential ($U_{B+}$) gelegt sind, dadurch gekennzeichnet, daß vier Stromspiegelverstärker (S1, S2, S3, S4) vorgesehen sind, daß die Stromeingangselektroden der Transistoren (T1, T2) des ersten Differenzverstärkers (I) mit dem Stromausgang (t1) des ersten Stromspiegelverstärkers (S1) und die Stromeingangselektroden der Transistoren (T3, T4) des zweiten Differenzverstärkers (II) mit dem Stromausgang (t1) des zweiten Stromspiegelverstärkers (S2) verbunden sind, daß ein dritter und ein vierter Differenzverstärker (III, IV) vorgesehen sind, daß je einer der beiden Ausgänge des dritten Differenzverstärkers (III) zur Steuerung je eines der beiden mit den Stromeingangselektrodenpaaren der Transistoren (T1 - T4) des ersten und des zweiten Differenzverstärkers (I, II) verbundenen Stromspiegelverstärker (S1, S2) dient, während die restlichen beiden Stromspiegelverstärker (S3, S4) durch je einen der beiden Ausgänge des vierten Differenzverstärkers (IV) gesteuert sind und ihrerseits mit ihrem Ausgang an die Steuerelektrode je eines der beiden Transistoren (T1, T2) des ersten Differenzverstärkers (I) gelegt und die Steuerelektroden der beiden Transistoren (T1, T2) des ersten Differenzverstärkers (I) über je ein Lastelement (L*) an das - nicht als Bezugspotential verwendete - andere Versorgungspotential ($U_{B+}$) der Schaltung gelegt sind.

2. Halbleiterschaltung nach Anspruch 1, dadurch gekennzeichnet, daß die Transistoren im ersten Differenzverstärker (I) sowie im zweiten Differenzverstärker (II) und in den vier Stromspiegelverstärkern (S1 - S4) sämtlich vom selben Leitungstyp ihrer Basiszone bzw. Kanalzone sind, während die den dritten und den vierten Differenzverstärker (III, IV) bildenden Transistoren zu den übrigen der genannten Transistoren komplementär ausgebildet sind.

3. Halbleiterschaltung nach Anspruch 1 oder 2, dadurch gekennzeichnet, daß die in den Differenzverstärkern (I-IV) und in den Stromspiegelverstärkern (S1 - S4) vorgesehenen Transistoren sämtlich als Bipolartransistoren ausgebildet sind.

4. Halbleiterschaltung nach einem der Ansprüche 1 bis 3, dadurch gekennzeichnet, daß die verwendeten Stromspiegelverstärker derart ausgebildet sind, daß die Stromeingangselektrode des Ausgangstransistors (t1) direkt oder über einen Widerstand (r) am Bezugspotential liegt und seine Steuerelektrode mit der den Eingang des Stromspiegels bildenden Anode einer insbesondere durch einen dem Ausgangstransistor (t1) gleichen Transistor (t2) mit kurzgeschlossener Basis-Kollektorstrecke gegebenen Diode (t2) verbunden ist, während die Kathode dieser Diode direkt oder über einen Widerstand (r) am Bezugspotential ($U_B.$) liegt.

5. Halbleiterschaltung nach einem der Ansprüche 1 bis 4, dadurch gekennzeichnet, daß bei gleicher Dimensionierung der beiden zur Aufnahme der Eingangsignale dienenden Differenzverstärker (III, IV) sowie der Stromspiegelschaltungen (S1 - S4) die Laufzeiten der Eingangsignale ($U_{eI}$, $U_{eII}$) bis zum Eingang der Kombination aus dem ersten und dem zweiten Differenzverstärker (I, II) identisch sind.

6.) Halbleiterschaltung nach einem der Ansprüche 1 bis 5, dadurch gekennzeichnet, daß die den ersten und den zweiten Differenzverstärker (I, II) bildenden Transistoren (T1 - T4) vom npn-Typ sind.

7. Halbleiterschaltung nach einem der Ansprüche 1 bis 6, dadurch gekennzeichnet, daß die beiden Ausgangsklemmen (A1, A2) auf das Bezugspotential ($U_B.$) der Schaltung bezogen sind.

8. Halbleiterschaltung nach einem der Ansprüche 1 bis 7, dadurch gekennzeichnet, daß die miteinander verbundenen Stromeingangselektroden des dritten und des vierten Differenzverstärkers (III, IV) über je eine Stromquelle (Q) an das als Bezugspotential für den betreffenden Differenzverstärker (III, IV) vorgesehene Versorgungspotential ($U_{B+}$) gelegt sind.

9. Halbleiterschaltung nach einem der Ansprüche 1 bis 8, <u>dadurch gekennzeichnet</u>, daß die Steuerelektroden der die beiden ersten Differenzverstärker (I, II) bildenden Transistoren über je ein Lastelement (L') an ein von den beiden Versorgungspotentialen abweichendes Hilfspotential gelegt sind.

**Claims**

1. An integratable signal-processing semiconductor circuit, in which four identical transistors (T1, T2, T3, T4) are combined in pairs via their current input electrodes (e.g. emitter-electrodes) so as to form a first and second differential amplifier (I, II), where a respective transistor (T2, T3) of the first differential amplifier (I) and of the second differential amplifier (II) are connected to one another via the control electrode (e.g. base) and are supplied with a first signal, whereas the likewise interconnected control electrodes of the two other transistors (T1, T4) are themselves controlled by a signal which, for example, is opposed in phase to the first signal, where moreover the four transistors (T1, T2, T3, T4) of the two differential amplifiers (I, II) are combined via their current output electrodes (e.g. collectors) and are, in each case, connected to one of the two signal output terminals (A1, A2) in such manner that the two transistors which are, in each case, connected to the same output terminal, are directly connected to one another only via their current output electrodes, and the current output electrodes of those transistors of the two differential amplifiers (I, II) which are connected to he two output terminals are connected to the supply potential ($U_{B+}$), <u>characterised in that</u> four current reflector amplifiers (S1, S2, S3, S4) are provided; that the current input electrodes of the transistors (T1, T2) of the first differential amplifier (I) are connected to the current output (t1) of the first current reflector amplifier (S1), and the current input electrodes of the transistors (T3, T4) of the second differential amplifier (II) are connected to the current output (t1) of the second current reflector amplifier (S2); that a third and fourth differential amplifier (III, IV) are provided; that one of the two outputs of the third differential amplifier (III) in each case serves to control one of the two current reflector amplifiers (S1, S2) which are connected to the current input electrode pairs of the transistors (T1 to T4) of the first and second differential amplifiers (I, II), whereas the remaining two current reflector amplifiers (S3, S4) are, in each case, controlled by one of the two outputs of the fourth differential amplifier (IV) and are themselves connected by their output to the control electrode of, in each case, one of the two transistors (T1, T2) of the first differential amplifier (I); and that the control electrodes of the two transistors (T1, T2) of the first differential amplifier (I) are in each case connected via a load element (L') to the other supply potential ($U_{B+}$) of the circuit, which is not used as a reference potential.

2. A semiconductor circuit as claimed in Claim 1, <u>characterised in that</u> the transistors in the first differential amplifier (I) and in the second differential amplifier (II), and in the four current reflector amplifiers (S1 to S4), are all of the same conductivity type in respect of their base zone and channel zone, whereas, the transistors which form the third and fourth differential amplifiers (III, IV), are complementary of design to the rest of the aforesaid transistors.

3. A semiconductor circuit as claimed in Claim 1 or 2, <u>characterised in that</u> the transistors provided in the differential amplifiers (I to IV), and in the current reflector amplifiers (S1 to S4), are all bipolar transistors.

4. A semiconductor circuit as claimed in one of Claims 1 to 3, <u>characterised in that</u> the current reflector amplifiers which are used are such that the current input electrode of the output transistor (t1) is connected either directly or via a resistor (r) to the reference potential, and its control electrode is connected to the anode, which forms the input of the current reflector, of a diode (t2), which is formed in particular by a transistor (t2) which is identical to the output transistor (t1) and which has a short-circuited base-collector path, whereas the cathode of this diode is connected either directly or via a resistor (r) to the reference potential ($U_{B.}$).

5. A semiconductor circuit as claimed in one of Claims 1 to 4, <u>characterised in that</u>, with identical dimensioning of the two differential amplifiers (III, IV) which serve to receive the input signals, and of the current reflector circuits (S1 to S4), the delay times of the input signals ($U_{eI}$, $U_{eII}$) to the input of the combination of the first and second differential amplifiers (I, II), are identical.

6. A semiconductor circuit as claimed in one of Claims 1 to 5, <u>characterised in that</u> the transistors (T1 to T4) which form the first and second differential amplifiers (I, II) are of the npn-type.

7. A semiconductor circuit as claimed in one of Claims 1 to 6, <u>characterised in that</u> the two output terminals (A1, A2) relate to the reference potential ($U_{B.}$) of the circuit.

8. A semiconductor circuit as claimed in one of Claims 1 to 7, <u>characterised in that</u> the two interconnected current input electrodes of the third and fourth differential amplifiers (III, IV) are, in each case, connected via a current source (Q) to the supply potential ($U_{B+}$) which is provided as a reference potential for the respective differential amplifier (III, IV).

9. A semiconductor circuit as claimed in one of Claims 1 to 8, <u>characterised in that</u> the control electrodes of the transistors which form the two first differential amplifiers (I, II) are, in each case, connected via a load element (L') to an auxiliary potential which differs from the two supply potentials.

## Revendications

1. Circuit semi-conducteur de traitement de signaux, réalisable en circuit intégré, dans lequel quatre transistors (T1, T2, T3, T4) identiques entre eux sont réunis par paires à travers leurs électrodes d'entrée du courant (leurs électrodes d'émetteur par exemple), avec formation d'un premier et d'un deuxième amplificateur différentiel (I, II), dans lequel un transistor (T2) du premier amplificateur différentiel (I) et un transistor (T3) du deuxième amplificateur différentiel (II) sont reliés entre eux à travers les électrodes de commande (les bases par exemple) et sont alimentés par un premier signal, tandis que les électrodes de commande des deux autres transistors (T1, T4), qui sont également reliées entre elles, sont commandées par un signal qui est par exemple en opposition de phase avec le premier signal, dans lequel, en outre, les quatre transistors (T1, T2, T3, T4) des deux amplificateurs différentiels (I, II) sont réunis par leurs électrodes de sortie du courant (leurs collecteurs par exemple) et sont reliés chacun à l'une des deux bornes de sortie de signal (A1, A2), de manière que les deux transistors reliés chaque fois à la même borne de sortie soient seulement en liaison directe entre eux par leurs électrodes de sortie du courant et les électrodes de sortie du courant des transistors reliés aux deux bornes de sortie des deux amplificateurs différentiels (I, II) soient reliées au potentiel d'alimentation ($U_{B+}$), caractérisé en ce que quatre amplificateurs (S1, S2, S3, S4) à circuit de courant dit à miroir (à rapport géométrique des aires d'émetteur) sont prévus, que les électrodes d'entrée de courant des transistors (T1, T2) du premier amplificateur différentiel (I) sont reliées à la sortie du courant (t1) du premier amplificateur à circuit de courant à miroir (S1) et les électrodes d'entrée du courant des transistors (T3, T4) du deuxième amplificateur différentiel (II) sont reliées à la sortie de courant (t1) du deuxième amplificateur à circuit de courant à miroir (S2), qu'un troisième et un quatrième amplificateur différentiel (II, IV) sont prévus, que chacune des deux sorties du troisième amplificateur différentiel (III) sert à la commande d'un des deux amplificateurs à circuit de courant à miroir (S1, S2) reliés aux paires d'électrodes d'entrée de courant des transistors (T1- T4) des premier et deuxième amplificateurs différentiels (I, II), tandis que les deux amplificateurs (S3, S4) restants à circuit de courant à miroir sont commandés chacun par l'une des deux sorties du quatrième amplificateur différentiel (IV) et sont eux-mêmes reliés par leur sortie à l'électrode de commande d'un des deux transistors (T1, T2) du premier amplificateur différentiel (I), les électrodes de commande des deux transistors (T1, T2) du premier amplificateur différentiel (I) étant reliées chacune à travers un élément de charge (L*) à l'autre potentiel d'alimentation ($U_{B+}$) - qui n'est pas utilisé comme potentiel de référence - du circuit.

2. Circuit semi-conducteur selon la revendication 1, caractérisé en ce que les transistors dans le premier amplificateur différentiel (I), de même que dans le deuxième amplificateur différentiel (II) et dans les quatre amplificateurs à circuit de courant à miroir (S1 - S4), sont tous du même type de conduction de leur zone de base ou de leur zone de canal, tandis que les transistors formant les troisième et quatrième amplificateurs différentiels (III, IV) sont réalisés complémentaires à ces transistors.

3. Circuit semi-conducteur selon la revendication 1 ou 2, caractérisé en ce que les transistors prévus dans les amplificateurs différentiels (I - IV) et dans les amplificateurs à circuit de courant à miroir (S1 - S4) sont tous des transistors bipolaires.

4. Circuit semi-conducteur selon une des revendications 1 à 3, caractérisé en ce que les amplificateurs à circuit de courant à miroir sont réalisés de manière que l'électrode d'entrée de courant du transistor de sortie (t1) soit reliée directement ou indirectement à travers une résistance (r) au potentiel de référence et que son électrode de commande soit reliée à l'anode, formant l'entrée du circuit de courant à miroir, d'une diode (t2) - constituée en particulier par un transistor (t2) qui est identique au transistor de sortie (t1) et dont le trajet base-collecteur est court-circuité - tandis que la cathode de cette diode est reliée directement ou à travers une résistance (r) au potentiel de référence ($U_{B.}$).

5. Circuit semi-conducteur selon une des revendications 1 à 4, caractérisé en ce que, en cas de dimensionnement égal des deux amplificateurs différentiels (III, IV) servant à recevoir les signaux d'entrée, ainsi que des circuits de courant à miroir (S1 - S4), les durées de parcours des signaux d'entrée ($U_{el}$, $U_{ell}$) jusqu'à l'entrée de la combinaison du premier (I) et du deuxième amplificateur différentiel (II) sont identiques.

6. Circuit semi-conducteur selon une des revendications 1 à 5, caractérisé en ce que les transistors (T1 - T4) formant les premier et deuxième amplificateurs différentiels (I, II) sont de type npn.

7. Circuit semi-conducteur selon une des revendications 1 à 6, caractérisé en ce que les deux bornes de sortie (A1, A2) sont rapportées au potentiel de référence ($U_{B.}$) du circuit.

8. Circuit semi-conducteur selon une des revencations 1 à 7, caractérisé en ce que les électrodes d'entrée de courant, reliées entre elles, des troisième et quatrième amplificateurs différentiels (III, IV) sont reliées chacune à travers une source de courant (Q) au potentiel d'alimentation ($U_{B+}$) prévu comme potentiel de référence pour l'amplificateur différentiel (III, IV) concerné.

9. Circuit semi-conducteur selon une des revendications 1 à 8, caractérisé en ce que les électrodes de commande des transistors formant les deux premiers amplificateurs différentiels (I, II), sont reliées chacune à travers un élément de charge (L*) à un potentiel auxiliaire qui diffère des deux potentiels d'alimentation.

# FIG 1

# FIG 2

# FIG 3

# FIG 4

# FIG 5

# FIG 6